# EUROPEAN PATENT APPLICATION

(11) **EP 1 684 366 A1**
(43) Date of publication of application: **26.07.2006**
(21) Application number: 05075195.7
(22) Date of filing: 25.01.2005
(51) Int. Cl.: H01L 51/52, H01L 27/00

(54) **Electronic device comprising an electronic component and encapsulation members**

(71) Applicant: Nederlandse Organisatie voor toegepast-natuurwetenschappelijk Onderzoek TNO, 2628 VK Delft (NL)
(72) Inventor: Rensing, Petrus Alexander, 5624 ER Eindhoven (NL); Denaard, Fabian Kevin, 5625 SK Eindhoven (NL); van Heck, Gerardus Titus, 5627 CS Eindhoven (NL); Bruinsma, Nienke Anita, 5621 EC Eindhoven (NL)
(74) Representative: Winckels, Johannes Hubertus F.

(57) **Abstract**

Method and means for manufacturing an electronic device which comprises an electronic component (21) and encapsulation members (24,25) fit to jointly encapsulate said electronic component after being sealed together. The electronic component and at least one of the encapsulation members comprise mutually matching conductor pairs (22/27,23/28) extending through the encapsulation members' sealing edges (26). The encapsulating members and the matching conductor pairs become sealed together by applying an adhesive between said sealing edges and pressing the encapsulating members and the matching conductor pairs together, said adhesive being or becoming conductive in the direction of said pressure. The adhesive preferably is an anisotropically conductive adhesive, e.g. comprising conductive spheres. Preferably, per matching conductor pair at least one conductor protrudes outside the plane of the respective encapsulating member's sealing edge. The electronic component may comprise a flat light emitting or electroluminescent component.

## Description

### FIELD OF THE INVENTION

The invention refers to a method for manufacturing an electronic device which comprises an electronic component and encapsulation members for encapsulating said electronic component. Moreover the invention relates to an electronic device comprising an electronic component and encapsulation members.

### BACKGROUND OF THE INVENTION

Nowadays electronic components like e.g. Organic Light Emitting Devices or Diodes (OLED), also known as Organic Electroluminescent Devices (OEL), Field Effect Transistors (FET) and Photo Voltaic Cells (PVC) in general are sensitive for oxidation and/or affection by moisture. For that reason those components may be encapsulated by encapsulation means, preventing that air and/or moisture can affect the sensitive component. Before sealing the encapsulation means, a getter may be included Such a getter may be fit to adsorb any moisture inside the encapsulation, e.g. caused by diffusion through the encapsulation's sealant.

The electronic component of course will have conductive members which have to be connected to conductive members outside the encapsulation means. Besides to conduct electricity, the conductive members may be used to drain away heat generated by the electronic component to an area outside the encapsulation means. A problem arises to find a smooth and simple solution to guide the electronic component's conductive members through the component's encapsulation wall, using minimum manufacturing effort.

### SUMMARY OF THE INVENTION

Hereinafter a new method will be presented for the manufacture of an electronic device which comprises an electronic component like e.g. an OLED etc. which, due to e.g. sensibility for oxidation and/or moisture, needs to be safeguarded by means of covering or encapsulation members which are fit to jointly encapsulate said electronic component after getting sealed together, including measures and means to guide the electronic component's conductive members through the encapsulation, using minimum manufacturing effort.

The electronic component and at least one of the encapsulation members comprise mutually matching conductor pairs which extend through the encapsulation members' sealing edges. The encapsulating members and the matching conductor pairs become sealed together by applying an adhesive between said sealing edges and pressing the encapsulating members and the matching conductor pairs together. The adhesive to be used is a conductive adhesive, e.g. having the form of a fluid, a paste, a tape or a wire, having the characteristic to be or to become conductive in the direction of the pressure performed upon the encapsulation members (and thus in the direction perpendicular to the plane of the encapsulation members' sealing edge). By performing the above the conductive adhesive is used for sealing together both (electrically non-conducting) encapsulation members as well as for connecting the matching contact pairs, viz. the electronic component's contacts with the contacts going outside the encapsulation, and e.g. connected to outside means fit for electrically feeding and/or controlling the electronic component.

The adhesive preferably is an anisotropically conductive adhesive, e.g. an adhesive, known as such, comprising conductive spheres, which will form a conductive path perpendicular to the plane of the encapsulation members' sealing edge when the adhesive, applied to the encapsulation members' edges, shrinks by being pressed together and/or under influence of other circumstances, e.g. due to the adhesive's curing process. At the locations of the conductor pairs -each comprising a contact member connected to the electronic component and a matching contact member (to be) connected with circuitry outside the encapsulation members- the matching conductors will be electrically (and/or thermally) connected the one another via the conductive path formed by the adhesive under pressure. Between the matching conductors, viz. along the plane of the encapsulation members' sealing edges, there will not be formed a conductive path, due to the anisotropical character of the adhesive w.r.t. its electrical (and thermal) conductivity behaviour.

Preferably, the locations of the matching conductors -together with the conductive adhesive film forming the conductive path from the electronic component to the outer world- will be shaped thus that at those locations, during the manufacturing process, the adhesive will experience more pressure than at the remaining locations, where no matching conductors are. To achieve such preferred shape, it is preferred that per matching conductor pair at least one conductor protrudes outside the plane of the respective encapsulating member's sealing edge. In this preferred embodiment the thickness of the relevant conductor or conductors, extending outside the plane of the sealing edge of the encapsulation member or member respectively cause that, at moving the encapsulation members together -the adhesive being located between their sealing edges- a relative high pressure will be applied at the locations of the matching conductor pair, resulting in forming a conductive path through the adhesive film between those conductors. Outside the locations of the matching conductors the pressure will be considerably lower or even about zero, resulting in the forming of a sealant which does seal the encapsulation members together -and thus protectively enclosing the inside electronic component- but without becoming conductive, because the adhesive is not urged to shrink in such a degree as to form any conductive path (e.g. by interconnection of conductive particles inside the adhesive compound).

The preferred option as discussed above appears to be very attractive for electronic devices having mainly a flat shape, enabling that use can be made of encapsulation members which also have a simple, flat constitution and e.g. may be formed by device components already needed for e.g. covering and/or supporting the electronic component. In this preferred embodiment, e.g. if the electronic component is a light emitting and/or light receiving component like an OLED, one encapsulation members may be formed by a transparent or translucent layer while a second encapsulation member may be formed by a supporting layer, e.g. a PCB.

Below the features discussed here will be elucidated with the help of some exemplary embodiments.

### EXEMPLARY EMBODIMENT

Figure 1 shows a prior art electronic device manufactured by using an conductive adhesive, derived from http://www.vtt.fi/tte/research/tte6/pdf_files/mikres98.pdf.
Figure 2 shows a prior art OLED embodiment, derived from http://www.gurunet.com/frames?cid=397247325&afid=333.
Figure 3 presents an exemplary embodiment of an electronic device made by applying the method as discussed in the previous paragraph.

Before pointing to the figures, in the first place some words may be dedicated to conductive adhesives. Such adhesives may consist of two basic components: solid fillers and a liquid adhesive fluid. The fillers conduct electricity (and often heat) and may be metal or metal-coated particles. The fillers are suspended in a fluid that, when cured, act as an adhesive and may have other mechanical characteristics favorable to their end use, such as shrinking (e.g. under pressure) to promote electrical conductivity among the particles. There are two basic types of conductive adhesives: isotropic (conducts electricity in all directions) and anisotropic (conducts electricity in a preferred direction). Silver and sometimes gold, usually in the form of flakes, are common fillers for isotropically conductive adhesives, adhesives that conduct electricity in all directions. Flakes are favorable shapes to promote particle-to-particle contact and provide electrical conductivity. Relatively soft metals promote good contact by deforming during the adhesive shrinking that takes place during cure. Soft metal fillers are also prone to "coining," where the particles press together to form large lumps. Silver and gold are also used in anisotropically conductive adhesives either as special shaped particles or to coat polymer spheres. These spheres or particles make an electrical connection between two contacts that are brought in close contact with each other.

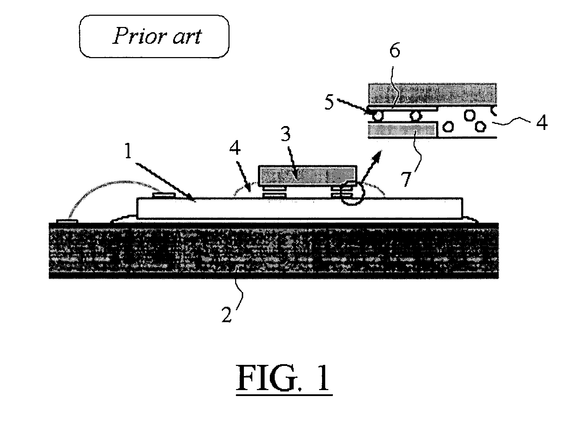

Figure 1 shows a prior art experimental electronic device, a prototype of which was manufactured using an anisotropic conductive adhesive (ACA). A so-called substrate chip 1 is glued upon a printed circuit board (PCB) 2 using an arbitrary adhesive. A so-called top chip 3 is glued upon the substrate chip 1 using an ACA 4. The ACA 4 comprises conductive particles 5 which interconnect contact members 6 and 7, forming a matching conductor pair, due to the small size of the adhesive film after the components 1 and 3 (and the conductors 6 and 7) are pressed together. Outside the location of the matching conductors 6 and 7 the adhesive will shrink less, due to the larger distance between the bottom surface of the top chip 5 and the top surface of the substrate chip 1. In the case the conductors 6 and 7 would not protrude beyond the planes of the respective surfaces of chip 3 and chip 1, the size between said surfaces would be equal to the distance between the conductors 6 and 7 the intermediate adhesive layer 4 -extending between the non-conducting surface parts of the chips 3 and 1- would shrink in the same rate as the adhesive layer between the conductors 6 and 7, resulting in a conductive glue layer between both surfaces (of non-conducting material) which, however, would not be affect a proper operation of the chips 4 and 1 due to the fact that the ACA 4 would only be conductive perpendicular to the direction of the glue layer (seal) plane (vertical in the figure) but not conductive in the direction of the glue layer (horizontal in the figure) and thus not causing short-circuit between the (visible) contact pair 6/7 and (not visible) further contact pairs.

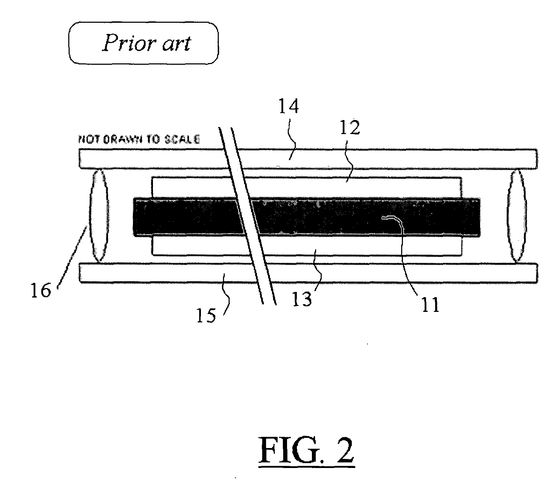

Figure 2 shows a prior art OLED embodiment. An Organic Light Emitting or Electroluminescent Device or Diode (OLED). OLEDs can be made using small-molecular weight organic materials (SM-OLEDs) or polymer-based materials (PLEDs, LEPs). Unlike LCDs and FEDs (Field Emission Displays), which are constructed of layered materials, OLEDs are monolithic devices, because each layer is deposited on the other, creating a single unit. Initially developed for display applications, OLEDs offer bright, colorful images with a wide viewing angle and low power. They do not need backlights as do LCD screens. OLEDs are commonly constructed on glass, but can also be fabricated on plastic and other flexible substrate films, such as Universal Display's Flexible OLED (FOLED). Display screens of this type are expected to have a dramatic impact on handheld devices in the future.

As figure 2 illustrates, in general a prior art OLED typically consists of a stack 11 of organic layers between two electrodes 12 and 13, both made of thin film coatings. At the top side the stacked layer 11 and conductive coating 12 may be covered by a transparent or translucent top layer 14, e.g. made of glass or plastic, while at the bottom side the stacked layer 11 and conductive coating 13 may be covered by a supporting layer 15 formed by any material, e.g. glass or organic material. According to the prior art, the top layer 14 and the bottom layer 15 may be surrounded by a perimeter sealant e.g. made by athermosetting adhesive like epoxy, forming a tight cross-linked polymer structure along the edges of the cover layers 14 and 15 and thus, together with those cover layers 14 and 15, encapsulating the proper OLED layers 11, 12, 13. The prior art does not, however, suggest what way the conductive layers 11 and 12 could be cut through the OLED encapsulation formed by the members 14 and 15 and the sealant 16.

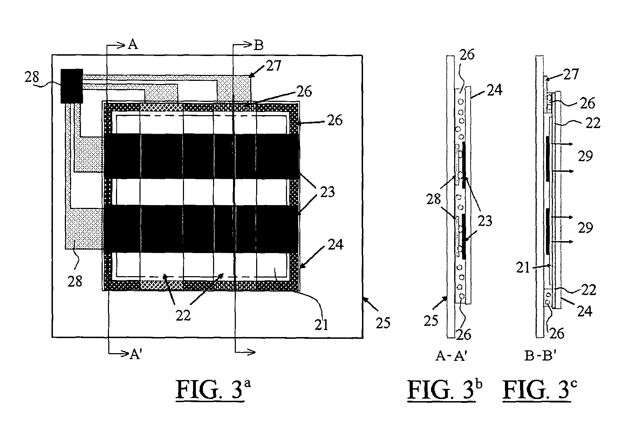

Figure 3 presents an exemplary embodiment of an electronic device made by applying the method as discussed in the previous paragraph. The electronic device illustrated in figure 3a, 3b and 3c, comprises an electronic component in the form of (e.g.) an OLED like shown in figure 2, comprising an organic layer 21 between two electrode configurations 22 and 23, both made of thin film coatings and e.g. together forming a conductive matrix line configuration, enabling to emit light at those locations where an electric voltage is applied -fed by outside control means- to the crossing conductive matrix lines at both sides of the organic layer 21.

At the top side the layer 21, including the conductive matrix lines 22, is covered by a transparent or translucent top layer 24, e.g. made of glass or plastic, fit to let pass light 29, generated by the organic electro-luminescent layer 21. At the bottom side the layer 21 and conductive lines 23 are covered by a supporting layer 25 formed by a PCB. Encapsulation members are formed by the top layer 24 at the top side and the PCB 25 at the bottom side. Both are -like in the prior art configuration shown in figure 2- sealed together by means of a sealant 26, jointly encapsulating the electronic component 21 (including the conductive layers 22 23).

The electronic component 21 and at least one of the encapsulation members comprise mutually matching conductor pairs 22/27 and 23/28 respectively, extending through the encapsulation members' sealing edges 26. The encapsulating members, formed by the top layer 24 and the supporting layer 25, as well as the matching conductor pairs 22/27 and 23/28 are sealed together by a perimeter sealing between the sealing edges 26. During the production of the electronic device, viz. an encapsulation step, the members 24 and 25, together with the conductor pairs 22/27 and 23/28 respectively are provided with the conductive adhesive in e.g. fluid or in tape or wire form, applied to the sealing edges 26 between the members 24 and 25 and between the respective contact pairs 22/27 and 23/28, after which they are pressed together. The adhesive applied is an ACA or another adhesive which is or becomes conductive in the direction perpendicular to the plane of the sealing edges 26 after being shrunken or constricted by pressure and/or (curing) heat applied to the adhesive during the manufacturing process.

As can be seen in figure 3a-c per matching conductor pair 22/27 and 23/28 at least one conductor, viz. conductors 27 and 28, applied to the supporting PCB layer 25 are protruding outside the plane of the sealing edge. For sake of a good understanding, the thickness of the conductors 27 and 28, extending between their counterpart conducting layers 22 and 23 respectively and a feeding and/or control chip 29 also located at the PCB 25, will be in the order of 25 µm, the thickness of the conducting layers in the order of 0.1µm. The thickness of the glue layer 26 between the matching conductors is in the order of the size of the conducting particles, which may be e.g. about 10 µm.. Outside those locations of matching conductors the adhesive layer 26 would have a thickness of about 35 µm then.

If the conductors 27 and 28 ―different from figure 3- are configured in any way in which they do not protrude outside the planes of the surface the PCB 25 (about 25 µm in figure 3), the distance between the bottom surface of the top layer 24 and the top surface of the PCB 25 would be -after being glued together- about equal to the distance between the conductors 27 and 28, in this case about 10 µm., resulting in a conductive seal between both surfaces. As long as both, the cover member 24 and the supporting PCB 25 are made of non-conducting materials a proper operation of the electronic component 22 will not affected, due to the fact that the ACA based sealant 26 will only be conductive in the direction perpendicular to plane of the members 24 and 25 (vertical in the figure) and not (conductive) in the direction of the seal itself (horizontal in the figure) and thus not causing any short-circuit between the mutual individual contact pairs 22/27 and 23/28 respectively.

## Claims

1. Method for manufacturing an electronic device which comprises an electronic component (21) and encapsulation members (24,25) fit to jointly encapsulate said electronic component after being sealed together, the electronic component and at least one of the encapsulation members comprising mutually matching conductor pairs (22/27,23/28) extending through the encapsulation members' sealing edges (26), the encapsulating members and the matching conductor pairs becoming sealed together by applying an adhesive between said sealing edges and pressing the encapsulating members and the matching conductor pairs together, said adhesive being or becoming conductive in the direction of said pressure.

2. Method according to claim 1, said adhesive being an anisotropically conductive adhesive.

3. Method according to claim 2, said adhesive comprising conductive spheres.

4. Method according to claim 1, per matching conductor pair at least one conductor protruding outside the plane of the respective encapsulating member's sealing edge.

5. Method according to claim 1, said electronic component as well as said encapsulation members having mainly a plane shape.

6. Method according claim 5, said electronic component being a flat light emitting or electroluminescent component.

7. Electronic device which comprises an electronic component (21) and encapsulation members (24,25) being sealed together and fit to jointly encapsulate said electronic component, the electronic component and at least one of the encapsulation members comprising mutually matching conductor pairs (22/27,23/28) extending through the encapsulation members' sealing edges, the encapsulating members and the matching conductor pairs being sealed together by an adhesive between said sealing edges, the encapsulating members and the matching conductor pairs being pressed together and the adhesive being conductive in the direction perpendicular to the plane of said sealing edges pressed together.

8. Electronic device according to claim 7, said adhesive being an anisotropically conductive adhesive.

9. Electronic device according to claim 8, said adhesive comprising conductive spheres.

10. Electronic device according to claim 7, per matching conductor pair at least one conductor protruding outside the plane of the respective encapsulating member's sealing edge.

11. Electronic device according to claim 7, said electronic component as well as said encapsulation members having mainly a plane shape.

12. Electronic device according claim 11, said electronic component being a flat light emitting or electroluminescent component.
